# EUROPÄISCHE PATENTSCHRIFT

(11) **EP 2 011 262 B1**
(45) Veröffentlichungstag und Bekanntmachung des Hinweises auf die Patenterteilung: **09.12.2009**
(21) Anmeldenummer: 07723458.1
(22) Anmeldetag: 21.03.2007
(51) Int. Cl.: H04J 3/04, H04J 3/06, H03M 9/00, G01R 31/317

(54) **VORRICHTUNG ZUR PARALLEL-SERIELL-WANDLUNG VON MEHREREN DURCH JEWEILS EINEN DETEKTOR ERFASSTEN SIGNALGRÖSSEN**
APPARATUS FOR PARALLEL/SERIAL CONVERSION OF A PLURALITY OF SIGNAL VARIABLES WHICH ARE EACH DETECTED BY A DETECTOR
DISPOSITIF DE CONVERSION PARALLELE-SERIE DE PLUSIEURS GRANDEURS DE SIGNAUX CHACUNE SAISIES PAR UN CAPTEUR

(30) Priorität: 26.04.2006 DE 102006019486
(43) Veröffentlichungstag der Anmeldung: 07.01.2009
(73) Patentinhaber: Rohde & Schwarz GmbH & Co. KG, 81671 München (DE)
(72) Erfinder: HUBER, Johann, 85570 Markt Schwaben (DE); REINHOLD, Michael, 81929 München (DE)
(74) Vertreter: Körfer, Thomas
(86) Internationale Anmeldenummer: PCT/EP2007/002501
(87) Internationale Veröffentlichungsnummer: WO 2007/144035

(56) Entgegenhaltungen:
- DE-A1- 4 407 948
- US-B1- 6 327 275

## Beschreibung

Die Erfindung betrifft eine Vorrichtung zur Parallel-Seriell-Wandlung von mehreren durch jeweils einen Detektor erfassten Signalgrößen.

In Messgeräten bzw. -Systemen, insbesondere in Spektrumanalysatoren und Netzwerkanalysatoren, werden im allgemeinen mehrere Signalgrößen eines elektrischen bzw. nachrichtentechnischen Signals mittels Detektoren erfasst und in einer nachfolgenden Verarbeitungsstufe ausgewertet. Bei den Signalgrößen eines Signals kann es sich beispielsweise um die Amplitude oder die Phase des Signals handeln. Aus den Abtastwerten dieser Signalgrößen werden in einer nachfolgenden Verarbeitungsstufe Auswertegrößen - beispielsweise der Maximalwert, der Minimalwert, der Durchschnittswert, der quadratische Mittelwerte usw. - ermittelt.

Da die einzelnen Signalgrößen und Auswertegrößen in unterschiedlichen Messkanälen erfasst und verarbeitet werden, in denen Funktionseinheiten, beispielsweise Filterstufen, mit unterschiedlichen Gruppenlaufzeiten realisiert sind, weisen diese Signalgrößen und Auswertegrößen unterschiedliche Datenlaufzeiten auf und sind nicht zueinander synchronisiert.

Aus der DE 199 61 131 A1 ist eine Vorrichtung und ein Verfahren zum Ausgleich unterschiedlicher Datenlaufzeiten mehrerer quasi-parallel anfallender Daten bekannt. Die einzelnen zueinander nicht synchronisierten Eingangssignale werden über eine Synchronisiereinheit synchronisiert in einem Zwischenspeicher - RAM - abgespeichert und zueinander synchronisiert als serielle Ausgangssignale ausgegeben. Die Synchronisiereinheit besteht dabei aus einem variablen Schieberegister, in das das jeweilige Eingangssignal seriell eingelesen wird, und einer Zustandsmaschine, die die Durchgangszeit des Eingangssignals durch das jeweilige Schieberegister in Abhängigkeit der bisherigen Datenlaufzeit des Eingangssignals steuert. Um die Synchronisierung der einzelnen Eingangssignale zueinander zu gewährleisten, werden die zu den einzelnen Schieberegistern gehörigen Zustandsmaschinen mittels eines gemeinsamen Synchronisiersignals zueinander zeitlich referenziert.

Diese zeitliche Referenzierung der einzelnen Zustandsmaschinen und der dazugehörigen variablen Schieberegister mittels eines gemeinsamen Synchronisiersignals mit einer bestimmten Taktrate beschränkt die Synchronisierung der einzelnen Eingangssignale auf Signale mit identischer Datenrate. Da in Messgeräten bzw. -Systemen die Detektion und die Signalverarbeitung der einzelnen Signalgrößen des zu messenden Signals in unterschiedlichen Datenraten vom Anwender parametriert werden kann, scheidet eine derartige Vorrichtung und ein derartiges Verfahren nach dem Stand der Technik für den Einsatzbereich in der Messtechnik aus.

Die deutsche Offenlegungsschrift DE 44 07 948 A1 zeigt eine Vorrichtung zur Parallel-Seriell-Wandlung von Auswertegrößen. Sobald gültige Daten vorliegen, wird ein "Daten-gültig"-Signal gesendet. Es wird jedoch lediglich die Verarbeitung identischer Datenraten gezeigt.

Die US Patentschrift US-B1 6 327 275 zeigt einen Remultiplexer, in welchem Datenströme variable Bitraten empfangen verarbeitet und wieder gemultiplext werden. Dabei werden die variablen Bitraten geschätzt. Eine Synchronisierung zwischen den zu multiplexenden Datenströmen erfolgt mittels einer zentralen Steuerung. Dabei wird jedoch lediglich die höchste Bitrate berücksichtigt. Die Bitrate übriger Datenströme spielt keine Rolle.

Aufgabe der Erfindung ist es deshalb, die Vorrichtung nach dem Stand der Technik dahingehend weiterzuentwickeln, dass auch Signalgrößen eines zu messenden Signals, welche jeweils mit einer unterschiedlichen Datenrate erfasst und verarbeitet werden, zueinander synchronisiert werden und somit eine zeitkorrekte Darstellung der einzelnen Signalgrößen eines Signals auf einem Sichtgerät möglich ist.

Die Aufgabe wird durch die Vorrichtung mit den Merkmalen des Anspruchs 1 gelöst. Vorteilhafte Weiterbildungen sind in den Unteransprüchen angegeben.

Da für eine zeitkorrekte Darstellung mehrerer Signalgrößen eines Signals mit unterschiedlicher Datenrate die Ausrichtung der Synchronisierung der einzelnen zu messenden und darzustellenden Signalgrößen eines Signals an der zeitkritischsten Signalgröße - Signalgröße mit der höchsten Datenrate - zu erfolgen hat, wird erfindungsgemäß ein Synchronisiersignal zur synchronisierten Zwischenspeicherung der einzelnen Signalgrößen in einem ersten Zwischenspeicher und zur anschließenden zeitkorrekten Visualisierung der einzelnen Signalgrößen zueinander in einem Sichtgerät aus dem zur jeweiligen Signalgröße gehörigen Freigabesignal mit der höchsten Datenrate gewonnen.

Dieses Freigabesignal, das von dem das Signal bzw. die Signalgröße erfassenden Detektor bei korrekter Detektion des Signals bzw. der Signalgröße aktiviert wird, dient zusätzlich auch zur Vorabspeicherung der Signalgröße und der aus der Signalgröße durch Auswertung jeweils ermittelter Auswertegrößen in einem dem jeweiligen Detektor zugeordneten und dem ersten Zwischenspeicher vorgelagerten zweiten Zwischenspeicher. Mit korrekt erfolgter Abspeicherung der Signalgröße bzw. der daraus ermittelten Auswertegrößen im jeweiligen zweiten Zwischenspeicher wird der dem zweiten Zwischenspeicher zugeordnete Detektor zurückgesetzt und ist somit für eine erneute Erfassung eines neuen Abtastwertes der Signalgröße bereitet.

Um die im zweiten Zwischenspeicher zwischengepufferte Signalgröße der höchsten Datenrate mit ihren ebenfalls im zweiten Zwischenspeicher zwischengepufferten Auswertegrößen nach Aktivierung des zugehörigen Freigabesignals vom zweiten Zwischenspeicher mit den anderen ebenfalls in einem zweiten Zwischenspeicher zwischengepufferten Signalgrößen niedrigerer Datenrate und deren Auswertegrößen im ersten Zwischenspeicher synchronisiert abzuspeichern, wird das Freigabesignal mit der höchsten Datenrate um einen Systemtaktzyklus verzögert und mit einem Signal, das das Ende des seriellen Auslese-Zykluses des ersten Zwischenspeichers signalisiert, zur Erzeugung des Synchronisiersignals verknüpft.

Mit dem Synchronisiersignal werden alle in den einzelnen den jeweiligen Detektoren jeweils zugeordneten zweiten Zwischenspeichern zwischengepufferten Signalgrößen und deren zwischengepufferte Auswertegrößen, die seit der letzten Aktivierung des Synchronisiersignals in einem der zweiten Zwischenspeicher abgelegt wurden, nicht nur synchronisiert in den ersten Zwischenspeicher übertragen, sondern es wird auch das serielle Auslesen der synchronisiert im ersten Zwischenspeicher abgelegten Signalgrößen und deren Auswertegrößen aus dem ersten Zwischenspeicher gestartet.

Das serielle Auslesen des ersten Zwischenspeichers kann über eine vom Anwender parametrierte Liste auf einige bestimmte Signalgrößen und deren zugehörigen Auswertegrößen beschränkt werden. Zusätzlich kann das Datenformat der aus dem ersten Zwischenspeicher ausgelesenen Signalgrößen und Auswertegrößen in ein für einen nachfolgenden RAM-Speicher geeignetes Datenformat gewandelt werden.

Kommt es aufgrund einer fehlerhaften Programmierung der Vorrichtung zu einer erneuten Aktivierung des Synchronisiersignals, bevor der erste Zwischenspeicher vollständig innerhalb eines Auslesezykluses seriell ausgelesen wurde, so wird ein Fehlersignal aktiviert, mit dem die seit Aktivierung der Vorrichtung gezählten Freigabesignal-Impulse der höchsten Datenrate zu einer weiteren Fehleranalyse abgespeichert werden.

Ein Ausführungsbeispiel der erfindungsgemäßen Vorrichtung zur Parallel-Seriell-Wandlung von mehreren durch jeweils einen Detektor erfassten Signalgrößen wird im Folgenden anhand der Zeichnung im Detail erklärt. Die Figuren der Zeichnung zeigen:
- Fig. 1: ein Blockschaltbild eines Spektrumanalysa- tors, bei dem die erfindungsgemäße Vorrich- tung zur Parallel-Seriell-Wandlung von meh- reren durch jeweils einen Detektor erfassten Signalgrößen zum Einsatz kommen kann,
- Fig. 2: ein Blockschaltbild der Funktionseinheiten zur parallelen Abspeicherung von mehreren durch jeweils einen Detektor erfassten Sig- nalgrößen der erfindungsgemäßen Vorrichtung,
- Fig. 3: ein Blockschaltbild der Funktionseinheiten zur Parallel-Seriell-Wandlung der parallel abgespeicherten Signalgrößen der erfindungs- gemäßen Vorrichtung und
- Fig. 4: ein Zeitdiagramm der einzelnen zu einem Detektor jeweils gehörigen Freigabesignale und des daraus erzeugten Synchronisier- signals.

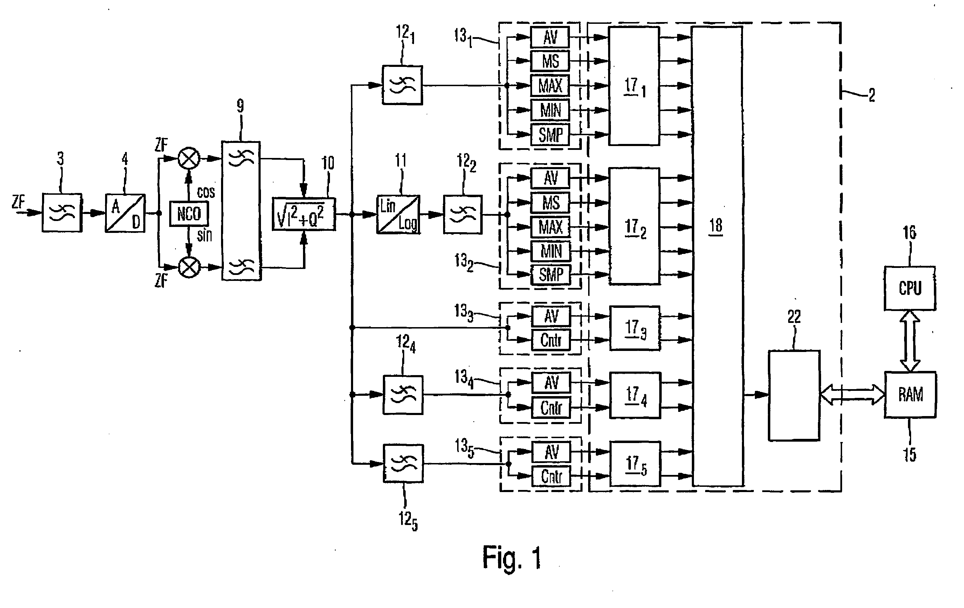

Fig. 1 zeigt einen Spektrumanalysator 1, der beispielhaft ein Messgerät bzw. -System darstellt, in dem die erfindungsgemäße Vorrichtung 2 zur Parallel-Seriell-Wandlung von mehreren durch jeweils einen Detektor erfassten Signalgrößen zum Einsatz kommen kann. In Fig. 1 ist nur der dafür interessierende Signalbereich unterhalb der Zwischenfrequenz-Stufe dargestellt.

Das mit ZF bezeichnete Zwischenfrequenzsignal wird in einem Tiefpass 3 gefiltert. An den Tiefpass 3 schließt sich ein Analog/Digital-Wandler 4 an. Anschließend erfolgt die I/Q-Mischung ins Basisband in einem I/Q-Demodulator 5, der in üblicher Weise aus einem numerisch gesteuerten Oszillator (NCO) 6 mit zwei um 90° phasenverschobenen Ausgängen besteht, die zusammen mit den gefilterten und analog/digital-gewandelten Zwischenfrequenzsignal jeweils einem Mischer 7 des I-Zweiges und einem Mischer 8 des Q-Zweiges zugeführt werden.

Daran schließt sich die digitale Filterung 9 an. Schließlich erfolgt die Betragsbildung in einem Betragsbildner 10. Die Logarithmierug erfolgt in einem Logarithmierer 11. Auf den Logarithmierer 11 folgt ein Videofilter 12₂ und daran anschließend ein Detektor 13₂ zur Erfassung beispielsweise der Amplitude des Basisbandsignals.

Zur Detektion anderer Signalgrößen des Basisbandsignals - beispielsweise Signal-Rausch-Abstand oder DC-Anteil des Basisbandsignals usw. - wird das Basisbandsignal am Ausgang des Betragsbildners 10 abgegriffen und über mehrere parallele Signalpfade weiteren Detektoren 13₁, 13₃, 13₄ oder 13₅ zugeführt.

Der Detektor 13₁ wird über das Tiefpassfilter 12₁ mit dem Basisbandsignal am Ausgang des Betragsbildners 10 versorgt. Der Detektor 13₃ wird direkt mit dem Basisbandsignal am Ausgang des Betragsbildners 10 versorgt. Die Detektoren 13₄ oder 13₅ werden jeweils über die Tiefpassfilter 12₄ oder 12₅ vom Ausgang des Betragsbildners 10 gespeist.

In den einzelnen Detektoren 13₁, 13₂, 13₃, 13₄ oder 13₅ erfolgt neben der Erfassung der einzelnen Signalgrößen auch eine erste statistische Auswertung. In jeweils einer Auswertungseinheit AV wird der Mittelwert der im jeweiligen Detektor 13₁, 13₂, 13₃, 13₄ oder 13₅ erfassten Signalgröße ermittelt. In jeweils einer Auswertungseinheit MS wird der quadratische Mittelwert der im jeweiligen Detektor 13₁ und 13₂ erfassten Signalgröße ermittelt. In jeweils einer Auswertungseinheit MAX wird der maximale Wert der im jeweiligen Detektor 13₁ und 13₂ erfassten Signalgröße ermittelt. In jeweils einer Auswertungseinheit MIN wird der minimale Wert der im jeweiligen Detektor 13₁ und 13₂ erfassten Signalgröße ermittelt. In einer Auswertungseinheit Cntr des Detektors 13₃, 13₄ oder 13₅ wird die Anzahl der Abtastwerte gezählt. Darüber hinaus können auch noch andere Auswertungseinheiten zum Einsatz kommen. Schließlich werden in einem Register SMP der jeweils letzte Abtastwert der im jeweiligen Detektor 13₁ und 13₂ erfassten Signalgrößen eines Auswertungszykluses zwischengespeichert.

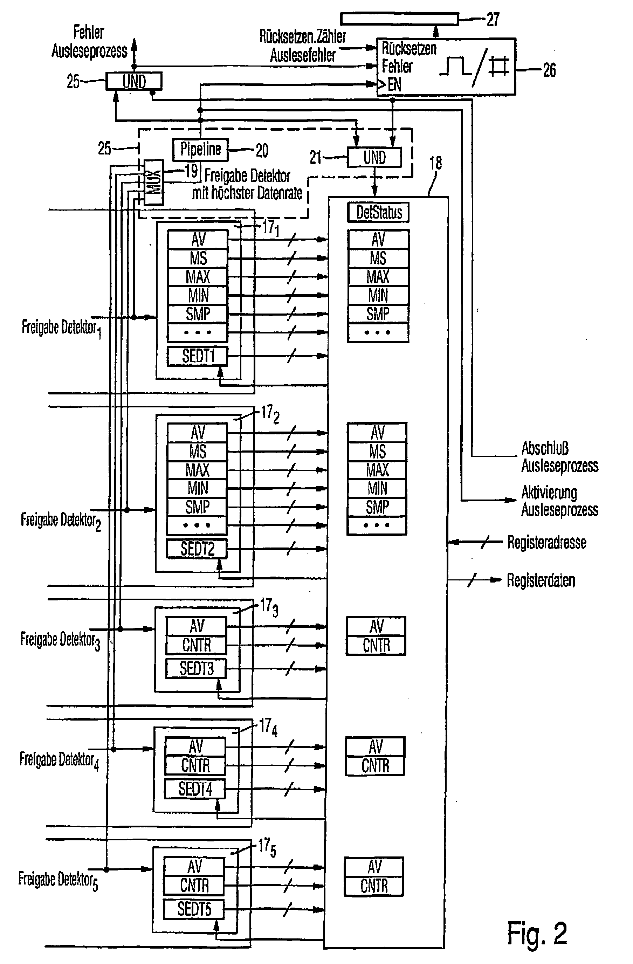

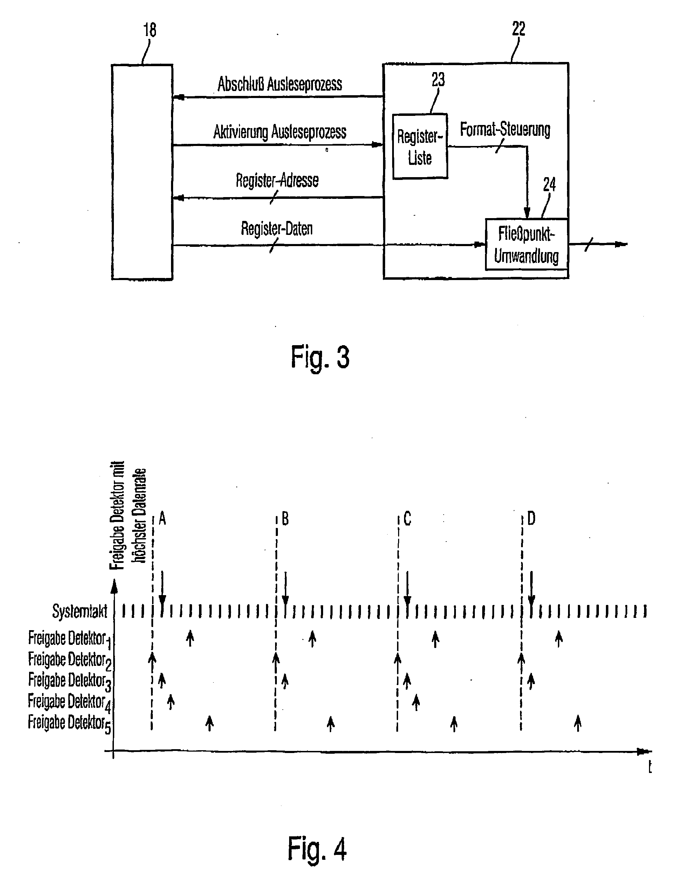

Die Ausgänge der einzelnen Auswertungseinheiten AV, MS, MAX, MIN und SMP in den einzelnen Detektoren 13₁, 13₂, 13₃, 13₄ und 13₅ werden der erfindungsgemäßen Vorrichtung 2 zur Parallel-Seriell-Wandlung von mehreren durch jeweils einen Detektor erfassten Signalgrößen, die im folgenden anhand der Blockschaltbilder in Fig. 2 und 3 beschrieben wird, zugeführt. Die in der erfindungsgemäßen Vorrichtung 2 zur Parallel-Seriell-Wandlung von mehreren durch jeweils einen Detektor erfassten Signalgrößen seriell ausgegebenen Auswertegrößen werden in einen RAM-Speicher 15 eingeschrieben. Aus diesem RAM-Speicher 15 werden die darin abgelegten Auswertegrößen von einer ProzessorEinheit - CPU - 16 ausgelesen und einem Sichtgerät zugeführt.

Die erfindungsgemäße Vorrichtung 2 zur Parallel-Seriell-Wandlung von mehreren durch jeweils einen Detektor erfassten Signalgrößen besteht gemäß Fig. 2 aus zweiten Zwischenspeichern 17₁, 17₂, 17₃, 17₄ und 17₅, die jeweils einem Detektor 13₁, 13₂, 13₃, 13₄ und 13₅ zugeordnet sind, und einem den zweiten Zwischenspeichern 17₁, 17₂, 17₃,17₄ und 17₅ nachgeschalteten ersten Zwischenspeicher 18. Die zweiten Zwischenspeicher 17₁, 17₂, 17₃, 17₄ und 17₅ weisen analog zu den Detektoren 13₁, 13₂, 13₃, 13₄ und 13₅ Zwischenpuffer für die Auswertegrößen - AV für den Mittelwert, MS für den quadratischen Mittelwert, MAX für den Maximalwert, MIN für den Minimalwert, Cntr für die Anzahl der Abtastwerte, SMP für den letzten Abtastwert eines Auswertungszykluses und weitere Zwischenpuffer für weitere Auswertegrößen auf.

Mit den von den jeweiligen Detektoren 13₁, 13₂, 13₃, 13₄ und 13₅ erzeugten Freigabesignalen DetRes₁, DetRes₂, DetRes₃, DetRes₄ und DetRes₅, die bei Anliegen einer gültigen Auswertegröße aktiviert werden, werden die einzelnen Auswertegrößen in die einzelnen Zwischenpuffer der zweiten Zwischenspeicher 17₁, 17₂, 17₃, 17₄ und 17₅ eingelesen. Die Aktualisierung der Zwischenpuffer der zweiten Zwischenspeicher 17₁, 17₂, 17₃, 17₄ und 17₅ während des aktuellen Detektion-Zykluses wird durch Setzen des Statusbits SDET₁, SDET₂, SDET₃, SDET₄ und SDET₅ im jeweiligen zweiten Zwischenspeicher 17₁, 17₂, 17₃, 17₄ und 17₅ gekennzeichnet. Mit der Aktualisierung der jeweiligen Zwischenpuffer der zweiten Zwischenspeicher 17₁, 17₂, 17₃, 17₄ und 17₅ werden die jeweiligen Detektoren 13₁, 13₂, 13₃, 13₄ und 13₅ für eine erneute Datenerfassung zurückgesetzt.

Die einzelnen Zwischenpuffer der zweiten Zwischenspeicher 17₁, 17₂, 17₃, 17₄ und 17₅ sind mit korrespondierenden Zwischenpuffern des ersten Zwischenspeicher 18 verbunden. Zur synchronisierten Übertragung der in den einzelnen Zwischenpuffer der zweiten Zwischenspeicher 17₁, 17₂, 17₃, 17₄ und 17₅ zwischengespeicherten Auswertegrößen in die korrespondierenden Zwischenpuffer des ersten Zwischenspeicher 18 wird über den Multiplexer 19 aus allen Freigabesignal DetRes₁, DetRes₂, DetRes₃, DetRes₄ und DetRes₅ das Freigabesignal MasterDetRes mit der höchsten Datenrate ausgewählt und einem als Verzögerungsstufe dienenden Pipelinebaustein 20 weitergeschaltet. In Pipelinebaustein 20 wird das Freigabesignal MasterDetRes mit der höchsten Datenrate um einen Systemtaktzyklus SYSCLK verzögert.

Das um einen Systemtaktzyklus SYSCLK verzögerte Freigabesignal MasterDetRes mit der höchsten Datenrate wird mit einem Signal DetStoreFinished, das den Auslesezyklus des ersten Zwischenspeichers 18 signalisiert, in einem UND-Gatter 21 verknüpft und ergibt das Synchronisiersignal, mit dem die synchronisierte Übertragung der in den einzelnen zweiten Zwischenspeichern 17₁, 17₂, 17₃, 17₄ und 17₅ innerhalb des letzten Zykluses der Detektion zwischengespeicherten Auswertegrößen mit der höchsten Datenrate in den ersten Zwischenspeicher 18 erfolgt. Die Statusregister SDET₁, SDET₂, SDET₃, SDET₄ und SDET₅ der zweiten Zwischenspeicher 17₁, 17₂, 17₃, 17₄ und 17₅ kennzeichnen, ob die einzelnen Zwischenspeicher 17₁, 17₂, 17₃, 17₄ und 17₅ im zurückliegenden Detektionszyklus aktualisiert wurden. Die Inhalte der Statusregister SDET₁, SDET₂, SDET₃, SDET₄ und SDET₅ werden mit der synchronisierten Übertragung der einzelnen Auswertegrößen von den zweiten Zwischenspeichern 17₁, 17₂, 17₃, 17₄ und 17₅ in das Statusregister DetStatus des ersten Zwischenspeichers 18 übertragen.

Mit synchronisierter Übertragung der jeweiligen Auswertungsgrößen von den einzelnen zweiten Zwischenspeicher 17₁, 17₂, 17₃, 17₄ und 17₅ in den ersten Zwischenspeicher 18 werden die aktivierten Statusbits SDET₁, SDET₂, SDET₃, SDET₄ und SDET₅ im jeweiligen zweiten Zwischenspeicher 17₁, 17₂, 17₃, 17₄ und 17₅ vom ersten Zwischenspeicher 18 zurückgesetzt.

Das verzögerte Freigabesignal MasterDetRes wird nicht nur als Synchronisiersignal, sondern auch als Signal StartStoreResult zur Aktivierung des seriellen Ausleseprozesses der einzelnen im ersten Zwischenspeicher 18 innerhalb eines Zykluses synchronisiert übertragenen Auswertegrößen benutzt. Das Aktivierungssignal des Ausleseprozesses StartStoreResult wird hierzu einer Zustandsmaschine 22 zugeführt.

Anhand einer Registerliste 23, in der vom Anwender diejenigen Detektoren gekennzeichnet werden, deren Auswertegrößen von der Zustandsmaschine 22 seriell aus dem ersten Zwischenspeicher 18 auszulesen sind, werden von der Zustandsmaschinen 22 die zu den gekennzeichneten Detektor--Auswertegrößen gehörigen Speicheradressen Reg_Adr der einzelnen Zwischenpuffer im ersten Zwischenspeicher 18 seriell und zyklisch an den ersten Zwischenspeicher 18 angelegt. Nach Adressierung der jeweiligen Zwischenpuffer im ersten Zwischenspeicher 18 mit der Speicheradresse Reg_Adr werden die darin zwischengespeicherten Auswertegrößen über den Datenbus Reg_Dat vom ersten Zwischenspeicher 18 zur Zustandsmaschinen 22 übertragen.

In einer Konvertierungseinheit 24 in der Zustandsmaschine 22 werden die auf dem Datenbus Reg_Dat übertragenen Auswertegrößen anhand einer in der Registerliste 23 abgelegten Information FormatCntrl über einen auswertegrößenspezifischen Konvertierungsbedarf in ein für den nachfolgenden RAM-Speicher 15 geeignetes Datenformat gewandelt.

Nach Abschluss eines seriellen Auslesezykluses des ersten Zwischenspeicher 18 durch die Zustandsmaschine 22 wird von der Zustandsmaschine, wie oben beschrieben ist, das Signal DetStoreFinished, das den Abschluss eines Auslesezykluses des ersten Zwischenspeicher 18 signalisiert, aktiviert. Mit Aktivierung dieses Signals DetStoreFinished kann über das UND-Gatter 21 mit Eintreffen eines neuen Freigabe-Signalimpulses MasterDetRes der höchsten Datenrate eine erneute synchronisierte Übertragung und Abspeicherung der von mehreren Detektoren 13₁, 13₂, 13₃, 13₄ und 13₅ jeweils quasi-parallel ermittelten Auswertegrößen im ersten Zwischenspeicher 18 erfolgen.

Kommt es aufgrund einer Fehlprogrammierung der Detektoren 13₁, 13₂, 13₃, 13₄ und 13₅ - beispielsweise Auslesen von zu vielen Auswertegrößen aus dem ersten Zwischenspeicher 18 je Auslesezyklus - zu einer Aktivierung des Freigabesignals MasterDetRes mit der höchsten Datenrate, bevor der Auslesezyklus des ersten Zwischenspeicher 18 mit Aktivierung des Signals DetStoreFinished abgeschlossen ist, so wird gemäß Fig. 2 über den Gatterbaustein 25 ein Fehlersignal DetStoreError aktiviert. Dieses Fehlersignal DetStoreError dient zur Übertragung der im Zähler 26 gezählten Freigabe-Signalimpulse MasterDetRes der höchsten Datenrate in ein Fehlerregister 27. Dieses Fehlerregisters 27 kann vom Anwender für eine weitere Fehleranalyse verwendet werden.

Anhand des Zeitdiagramms in Fig. 4 ist noch einmal die Generierung des Synchronisiersignals zur synchronisierten Abspeicherung von in mehreren parallel arbeitenden Detektoren erfassten Signalgrößen und daraus ermittelten Auswertegrößen im ersten Zwischenspeicher 18 dargestellt. Das Freigabesignal DetRes₂ des Detektors 13₂ dient als ausgewähltes Freigabesignal MasterDetRes für die Generierung des Synchronisiersignals und wird im Pipelinebaustein 20 um einen Taktzyklus des Systemtakts SYSCLK verzögert. Zu den Zeitpunkten A, B, C und D wird jeweils das Synchronisiersignal erzeugt. In diesen Zeitpunkten werden alle Auswertegrößen von Detektoren in den ersten Zwischenspeicher 18 synchronisiert abgelegt. Wie aus Fig. 4 ersichtlich ist, weist das Freigabesignal DetRes₄ die halbe Datenrate gegenüber den Freigabesignalen DetRes₁, DetRes₂, DetRes₃ und DetRes₅ auf, so dass die Auswertegrößen des Detektors 13₄, die vom ersten Zwischenspeicher 18 in den RAM-Speicher 15 übertragen wurden, nur zu den Zeitpunkten B und D von der Zustandsmaschine 22 ausgelesen werden.

Die Erfindung ist nicht auf das dargestellte Ausführungsbeispiel beschränkt. Beispielsweise eignet sich die erfindungsgemäße Vorrichtung auch zur Parallel-Seriell-Wandlung von nicht aus einem Detektor stammenden asynchronen Signalen, beispielsweise bei einer Speicherverwaltung. Alle beschriebenen und gezeichneten Merkmale sind im Rahmen der Erfindung beliebig miteinander kombinierbar.

## Patentansprüche

1. Vorrichtung (2) mit mehreren Detektoren (13₁, 13₂, 13₃, 13₄, 13₅) , einem ersten Zwischenspeicher (18) zur synchronisierten Zwischenspeicherung jeder ermittelten Auswertegröße, einer Synchronisiereinheit (25) zur Erzeugung eines Synchronisiersignals zur synchronisierten Zwischenspeicherung und einer Einheit (22) zum seriellen Auslesen der im ersten Zwischenspeicher (18) synchronisiert abgespeicherten Auswertegrößen,
wobei die Vorrichtung dazu geeignet ist, eine Parallel-Seriell-Wandlung von mehreren durch jeweils einen der Detektoren (13₁, 13₂, 13₃, 13₄, 13₅) aus erfassten Signalgröße ermittelten Auswertegrößen durchzuführen,
wobei jeder der Detektoren (13₁ - 13₅) dazu geeignet ist, jeweils ein Freigabesignal zu erzeugen, das die Gültigkeit der ermittelten Auswertegröße kennzeichnet und,
**dadurch gekennzeichnet, dass**
ein von der Synchronisiereinheit (25) erzeugtes Synchronisiersignal aus demjenigen Freigabesignal (MasterDetRes) hervorgeht, das von allen zu den ermittelten Auswertegrößen jeweils gehörigen Freigabesignalen (DetRes₁, DetRes₂, DetRes₃, DetRes₄, DetRes₅) die höchste Datenrate aufweist.

2. Vorrichtung nach Anspruch 1,
**dadurch gekennzeichnet,**
**dass** die Erzeugung des zur ermittelten Auswertegröße gehörigen Freigabesignals (DetRes₁, DetRes₂, DetRes₃, DetRes₄, DetRes₅) durch einen der die Ermittlung der Auswertegröße durchführenden Detektoren (13₁, 13₂, 13₃, 13₄, 13₅) erfolgt.

3. Vorrichtung nach Anspruch 2,
**dadurch gekennzeichnet, dass** die Vorrichtung zweite Zwischenspeicher (17₁, 17₂, 17₃, 17₄, 17₅) umfasst, und **dass** die Zwischenspeicherung der vom Detektor (13₁, 13₂, 13₃, 13₄, 13₅) ermittelten Auswertegröße in einem der dem Detektor (13₁, 13₂, 13₃, 13₄, 13₅) zugeordneten zweiten Zwischenspeicher (17₁, 17₂, 17₃, 17₄, 17₅) und ein Rücksetzen des Detektors (13₁, 13₂, 13₃, 13₄, 13₅) nach Aktivierung des zugehörigen Freigabesignals durch den jeweiligen Detektor (13₁, 13₂, 13₃, 13₄, 13₅) erfolgt.

4. Vorrichtung nach einem der Ansprüche 1 bis 3,
**dadurch gekennzeichnet,**
**dass** die Vorrichtung dazu geeignet ist, die Aktivierung des Synchronisiersignals verzögert nach Aktivierung des Freigabesignal (MasterDetRes) mit der höchsten Datenrate durchzuführen.

5. Vorrichtung nach Anspruch 4, wenn von Anspruch 3 abhängig,
**dadurch gekennzeichnet,**
**dass** die Vorrichtung dazu geeignet ist, nach Beendigung des seriellen Auslesens der im ersten Zwischenspeicher (18) zuletzt synchronisiert abgespeicherten Auswertegrößen und mit verzögerter Aktivierung des Freigabesignals (MasterDetRes) mit der höchsten Datenrate eine synchronisierte Zwischenspeicherung der Auswertegrößen vom jeweiligen zweiten Zwischenspeicher (17₁, 17₂, 17₃, 17₄, 17₅) in den ersten Zwischenspeicher (18) durchzuführen.

6. Vorrichtung nach einem der Ansprüche 1 bis 5,
**dadurch gekennzeichnet,**
**dass** die Vorrichtung dazu geeignet ist, mit verzögerter Aktivierung des Synchronisiersignals das serielle Auslesen der im ersten Zwischenspeicher (18) synchronisiert zwischengespeicherten Auswertegrößen durchzuführen.

7. Vorrichtung nach einem der Ansprüche 1 bis 6,
**dadurch gekennzeichnet,**
**dass** für das serielle Auslesen der im ersten Zwischenspeicher (18) synchronisiert zwischengespeicherten Auswertegrößen einzelne Auswertegrößen auswählbar sind.

8. Vorrichtung nach Anspruch 3 oder 4 bis 7, wenn von Anspruch 3 abhängig,
**dadurch gekennzeichnet,**
**dass** die Vorrichtung dazu geeignet ist, eine Abspeicherung von zu den einzelnen Signalgröße ermittelten Auswertegrößen im jeweiligen zweiten Zwischenspeicher (17₁, 17₂, 17₃, 17₄, 17₅) und im ersten Zwischenspeicher (18) durchzuführen.

9. Vorrichtung nach Anspruch 8,
**dadurch gekennzeichnet,**
**dass** die Vorrichtung dazu geeignet ist, nach dem seriellen Auslesen der im ersten Zwischenspeicher (18) synchronisiert zwischengespeicherten Auswertegrößen eine Konvertierung der Auswertegrößen in ein anderes Datenformat durchzuführen.

10. Vorrichtung nach Anspruch 8 oder 9,
**dadurch gekennzeichnet,**
**dass** die Vorrichtung dazu geeignet ist, im Fall einer erneuten Aktivierung des Synchronisiersignals während des seriellen Auslesens der im ersten Zwischenspeicher (18) synchronisiert zwischengespeicherten Auswertegrößen eine Aktivierung eines Fehlersignals (DetStoreError) durchzuführen.

## Claims

1. A device (2) with several detectors (13₁, 13₂, 13₃, 13₄, 13₅), a first buffer (18) for the synchronised buffering of every determined evaluated variable, a synchronisation unit (25) for the generation of a synchronisation signal for the synchronised buffering and a unit (22) for the serial reading out of the evaluated variables stored in a synchronised manner in the first buffer (18), wherein the device is suitable for the implementation of a parallel-serial conversion of several evaluated variables determined in each case by one of the detectors (13₁, 13₂, 13₃, 13₄, 13₅) from registered signal variables,
wherein each of the detectors (13₁ - 13₅) is suitable respectively for the generation of a release signal, which marks the validity of the determined evaluated variable and,
**characterised in that**
a synchronisation signal generated by the synchronisation unit (25) is obtained from the release signal (MasterDetRes), which, of all the release signals (DetRes₁, DetRes₂, DetRes₃, DetRes₄, DetRes₅) associated respectively with the determined evaluated variables, provides the highest data rate.

2. The device according to claim 1,
**characterised in that**
the generation of the release signal (DetRes₁, DetRes₂, DetRes₃, DetRes₄, DetRes₅) associated with the determined evaluated variable is implemented via one of the detectors (13₁, 13₂, 13₃, 13₄, 13₅) implementing the determination of the evaluated variable.

3. The device according to claim 2,
**characterised in that**
the device comprises second buffers (17₁, 17₂, 17₃, 17₄, 17₅), and
that the buffering of the evaluated variable determined by the detector (13₁, 13₂, 13₃, 13₄, 13₅) is implemented in one of the second buffers (17₁, 17₂, 17₃, 17₄, 17₅) allocated to the detector (13₁, 13₂, 13₃, 13₄, 13₅), and a resetting of the detector (13₁, 13₂, 13₃, 13₄, 13₅) after the activation of the associated release signal is implemented by the respective detector (13₁, 13₂, 13₃, 13₄, 13₅) .

4. The device according to any one of claims 1 to 3,
**characterised in that**
the device is suitable for the implementation of the activation of the synchronisation signal with a delay after activation of the release signal (MasterDetRes) with the highest data rate.

5. The device according to claim 4, if dependent upon claim 3,
**characterised in that**,
after the termination of the serial reading out of the evaluated variables last buffered in a synchronised manner in the first buffer (18) and with delayed activation of the release signal (MasterDetRes) with the highest data rate, the device is suitable for the implementation of a synchronised buffering of the evaluated variables from the respective second buffer (17₁, 17₂, 17₃, 17₄, 17₅) into the first buffer (18) .

6. The device according to any one of claims 1 to 5,
**characterised in that**,
with delayed activation of the synchronisation signal, the device is suitable for the implementation of the serial reading out of the evaluated variables buffered in a synchronised manner in the first buffer (18).

7. The device according to any one of claims 1 to 6,
**characterised in that**
individual evaluated variables are selectable for the serial reading out of the evaluated variables buffered in a synchronised manner in the first buffer (18).

8. The device according to claim 3 or 4 to 7, if dependent upon claim 3,
**characterised in that**
the device is suitable for the implementation of a buffering of evaluated variables determined at the individual signal variables in the respective second buffer (17₁, 17₂, 17₃, 17₄, 17₅) and in the first buffer (18).

9. The device according to claim 8,
**characterised in that**,
after the serial reading out of the evaluated variables buffered in a synchronised manner in the first buffer (18), the device is suitable for the implementation of a conversion of the evaluated variables into another data format.

10. The device according to claim 8 or 9,
**characterised in that**,
in the case of a re-activation of the synchronisation signal during the serial reading out of the evaluated variables buffered in a synchronised manner in the first buffer (18), the device is suitable for the implementation of an activation of an error signal (DetStoreError).

## Revendications

1. Dispositif (2) comportant plusieurs détecteurs (13₁, 13₂, 13₃, 13₄, 13₅), une première mémoire tampon (18) pour mettre en mémoire tampon de façon synchronisée chaque grandeur d'évaluation détectée, une unité de synchronisation (25) pour générer un signal de synchronisation en vue de la mise en mémoire tampon synchronisée et une unité (22) pour lire en série les grandeurs d'évaluation mémorisées de façon synchronisée dans la première mémoire tampon (18),
dans lequel le dispositif est approprié pour effectuer une conversion parallèle-série de plusieurs grandeurs d'évaluation détectées à partir de grandeurs de signaux détectées par l'un respectif des détecteurs (13₁, 13₂, 13₃, 13₄, 13₅),
dans lequel chacun des détecteurs (13₁-13₅) est approprié pour générer respectivement un signal d'autorisation, qui désigne la validité des grandeurs d'évaluation détectées et, **caractérisé en ce que**
un signal de synchronisation généré par l'unité de synchronisation (25) provient du signal d'autorisation (MasterDetRes), qui présente le taux de données le plus élevé parmi tous les signaux d'autorisation appropriés respectifs (DetRes₁, DetRes₂, DetRes₃, DetReS₄, DetRes₅) pour les grandeurs d'évaluation détectées.

2. Dispositif selon la revendication 1, **caractérisé en ce que**
la génération du signal d'autorisation (DetRes₁, DetRes₂, DetRes₃, DetRes₄, DetRes₅) approprié pour les grandeurs d'évaluation détectées est effectuée par l'un des détecteurs (13₁, 13₂, 13₃, 13₄, 13₅) effectuant la détection des grandeurs d'évaluation.

3. Dispositif selon la revendication 2,
**caractérisé en ce que** le dispositif comprend deuxième mémoires tampons (17₁, 17₂, 17₃, 17₄, 17₅), et
**en ce que** la mise en mémoire tampon des grandeurs d'évaluation détectées par le détecteur (13₁, 13₂, 13₃, 13₄, 13₅) est effectuée dans une seconde mémoire tampon (17₁, 17₂, 17₃, 17₄, 17₅) associée au détecteur (13₁, 13₂, 13₃, 13₄, 13₅) et une réinitialisation du détecteur (13₁, 13₂, 13₃, 13₄, 13₅) est effectuée après activation du signal d'autorisation associé par le détecteur respectif (13₁, 13₂, 13₃, 13₄, 13₅) .

4. Dispositif selon l'une des revendications 1 à 3, **caractérisé en ce que**
le dispositif est approprié pour effectuer avec le taux de données le plus élevé l'activation du signal de synchronisation ralentie après l'activation du signal d'autorisation (MasterDetRes).

5. Dispositif selon la revendication 4, si elle dépend de la revendication 3, **caractérisé en ce que**
le dispositif est approprié pour effectuer avec le taux de données le plus élevé une mise en mémoire tampon synchronisée des grandeurs d'évaluation par la seconde mémoire tampon respective (17₁, 17₂, 17₃, 17₄, 17₅) dans la première mémoire tampon (18) après la fin de la lecture en série des grandeurs d'évaluation mémorisées synchronisées en dernier dans la première mémoire tampon (18) et grâce à l'activation ralentie du signal d'autorisation (MasterDetRes).

6. Dispositif selon l'une des revendications 1 à 5, **caractérisé en ce que**
le dispositif est approprié pour effectuer la lecture en série des grandeurs d'évaluation mises en mémoire tampon synchronisées dans la première mémoire tampon (18) grâce à l'activation ralentie du signal de synchronisation.

7. Dispositif selon l'une des revendications 1 à 6, **caractérisé en ce que**
des grandeurs d'évaluation particulières peuvent être sélectionnées pour la lecture en série des grandeurs d'évaluation mises en mémoire tampon synchronisées dans la première mémoire tampon (18).

8. Dispositif selon la revendication 3 ou 4 à 7, lorsqu'elle dépend de la revendication 3, **caractérisé en ce que**
le dispositif est approprié pour effectuer une mémorisation des grandeurs d'évaluation détectées à partir des grandeurs de signaux particulières dans une seconde mémoire tampon respective (17₁, 17₂, 17₃, 17₄, 17₅) et dans la première mémoire tampon (18).

9. Dispositif selon la revendication 8, **caractérisé en ce que**
le dispositif est approprié pour effectuer une conversion des grandeurs d'évaluation dans un autre format de données après la lecture en série des grandeurs d'évaluation mises en mémoire tampon synchronisées dans la première mémoire tampon (18).

10. Dispositif selon la revendication 8 ou 9, **caractérisé en ce que**
le dispositif est approprié pour effectuer une activation d'un signal d'erreur (DetStoreError) dans le cas d'une nouvelle activation du signal de synchronisation pendant la lecture en série des grandeurs d'évaluation mises en mémoire tampon synchronisées dans la première mémoire tampon (18).
